Europäisches Patentamt

European Patent Office

Office européen des brevets

(19)

(11) Veröffentlichungsnummer : **0 107 772**
**B1**

(12) # EUROPÄISCHE PATENTSCHRIFT

(45) Veröffentlichungstag der Patentschrift : .
23.12.87

(51) Int. Cl.⁴ : **G 01 R 31/26**

(21) Anmeldenummer : **83109005.5**

(22) Anmeldetag : **12.09.83**

(54) **Verfahren zur Messung elektrischer Potentiale an vergrabener Festkörpersubstanz.**

(30) Priorität : **22.09.82 DE 3235100**

(43) Veröffentlichungstag der Anmeldung :
**09.05.84 Patentblatt 84/19**

(45) Bekanntmachung des Hinweises auf die Patenterteilung : **23.12.87 Patentblatt 87/52**

(84) Benannte Vertragsstaaten :
**DE GB NL**

(56) Entgegenhaltungen :
**EP-A- 0 005 762**
**SOLID-STATE ELECTRONICS, Band 22, Nr. 8, 1979 R. HEZEL "Electron-beam-induced-current investigations on MOS and MNOS devices", Seiten 735-742**

(73) Patentinhaber : **Siemens Aktiengesellschaft Berlin und München**
**Wittelsbacherplatz 2**
**D-8000 München 2 (DE)**

(72) Erfinder : **Schink, Helmut, Dipl.-Phys.**
**Knappertsbuschstrasse 5**
**D-8000 München 81 (DE)**

## Beschreibung

Die Erfindung betrifft ein Verfahren zur Messung elektrischer Potentiale an Festkörpersubstanz, die von einer Oberfläche durch mindestens eine leitende Schicht und mindestens eine isolierende Schicht getrennt ist, nach dem Oberbegriff des Patentanspruchs 1.

Elektrische Potentiale von Festkörpersubstanz, die unter einer isolierenden und einer leitenden Deckschicht verborgen ist, wie z. B. Potentiale unter der Gate-Elektrode einer MOS-Struktur oder wie z. B. Potentiale einer verborgenen Leitbahn innerhalb einer Mehrlagenverdrahtung, sollen ortsaufgelöst und zerstörungsfrei gemessen werden.

Befindet sich auf der Oberfläche einer Probe nur eine isolierende Deckschicht, so ist nach dem Stand der Technik eine Potentialmessung an Festkörpersubstanz, die unter dieser Deckschicht verborgen ist, in einem Raster-Elektronenmikroskop mit Hilfe der bekannten Methode des Potentialkontrasts möglich, wenn die Primärstrahlenergie groß genug ist, um in der gesamten Dicke der isolierenden Deckschicht einen leitfähigen Kanal zu bilden. Diese bekannte Methode versagt aber, wenn die isolierende Schicht ihrerseits zusätzlich durch eine leitende Deckschicht verdeckt ist. Zur Messung des Potentials an einer Festkörpersubstanz, die unter mindestens einer leitenden Schicht und mindestens einer isolierenden Schicht verdeckt ist, mußten daher bisher die darüberliegenden Schichten abgetragen werden.

Ein Verfahren zum Einprägen von Spannungen in ein mit einer Passivierungsschicht versehenes Halbleiterbauelement ist aus der europäischen Offenlegungsschrift EP-A-0 005 762 bekannt. Bei diesem Verfahren wird zumindest ein Teil der Oberfläche der Passivierungsschicht mit einer dünnen Metallschicht bedeckt, die man anschließend auf ein vorgegebenes Potential legt und mit einem Elektronenstrahl abtastet. Die Energie der Elektronen wird hierbei so eingestellt, daß die innerhalb der Passivierungsschicht erzeugte Leitfähigkeit ausreicht, den Metallfilm und die interessierende Leiterbahn des Bauelementes kurzzuschließen.

Aus der Veröffentlichung von R. Hezel « Electron-beam-induced-current investigations on MOS and MNOS devices » Solid-State-Electronics, Vol. 22 No. 8 (1979) S. 735-742 ist ein EBIC-Verfahren bekannt, mit dem Strukturfehler im Halbleitermaterial von MIS-Bausteinen durch Messung des induzierten Probenstromes in Abhängigkeit von der Zeit und der Bestrahlungsintensität festgestellt werden können.

Der vorliegenden Erfindung liegt die Aufgabe zugrunde, ein Verfahren der eingangs genannten Art anzugeben, mit dem elektrische Potentiale an einer Festkörpersubstanz auch dann gemessen werden können, wenn diese unter mindestens einer leitenden Schicht und mindestens einer isolierenden Schicht verborgen ist.

Diese Aufgabe wird erfindungsgemäß durch ein Verfahren nach dem Anspruch 1 gelöst. Durch Messung des durch ionisierende Strahlung, z. B. durch Elektronen in einem Raster-Elektronenmikroskop, in einer Isolatorschicht induzierten Stromes ist eine zerstörungsfreie Potentialmessung an einer Festkörpersubstanz auch dann möglich, wenn diese unter mindestens einer isolierenden Schicht und mindestens einer leitenden Schicht verborgen ist.

Das erfindungsgemäße Verfahren beruht darauf, daß der in einer Isolatorschicht, z. B. einem Gateoxid, von ionisierender Strahlung induzierte Strom von der an dieser Isolatorschicht anliegenden Spannung, z. B. zwischen Gate-Elektrode und Substrat, abhängig ist. Mit einem erfindungsgemäßen Verfahren kann z. B. in einem Raster-Elektronenmikroskop der pn-Übergang einer MOS-Struktur unterhalb einer Gate-Elektrode auch dann lokalisiert werden, wenn keine Sperrspannung am pn-Übergang anliegt. Mit einem erfindungsgemäßen Verfahren kann hierbei nachgewiesen werden, daß der Signalhub an diesem pn-Übergang linear mit der Sperrspannung anwächst.

Aus den bisher vorliegenden Experimenten läßt sich eine Ortsauflösung von 0,1 $\mu$m und eine Potentialauflösung von 0,1 V angeben. Mit einem erfindungsgemäßen Verfahren lassen sich auch elektrischen Inhomogenitäten z. B. an der Grenzfläche Substrat/Oxid in Halbleiterbauelementen lokalisieren und messen.

Ausgestaltungen und Vorteile der Erfindung sind in dem Unteranspruch, der Beschreibung und der Zeichnung dargestellt.

Ausführungsbeispiele der Erfindung werden im folgenden anhand der Zeichnung beschrieben.

Fig. 1 zeigt eine schematische Darstellung einer Versuchsanordnung für ein erfindungsgemäßes Verfahren.

Fig. 2 zeigt eine Versuchsanordnung für ein erfindungsgemäßes Verfahren in einem Raster-Elektronenmikroskop.

Fig. 3 zeigt eine Versuchsanordnung für ein erfindungsgemäßes Verfahren an einer MOS-Struktur mit pn-Übergang im Substrat.

Fig. 4 zeigt den Signalhub in Abhängigkeit von der am pn-Übergang in Fig. 3 angelegten Sperrspannung.

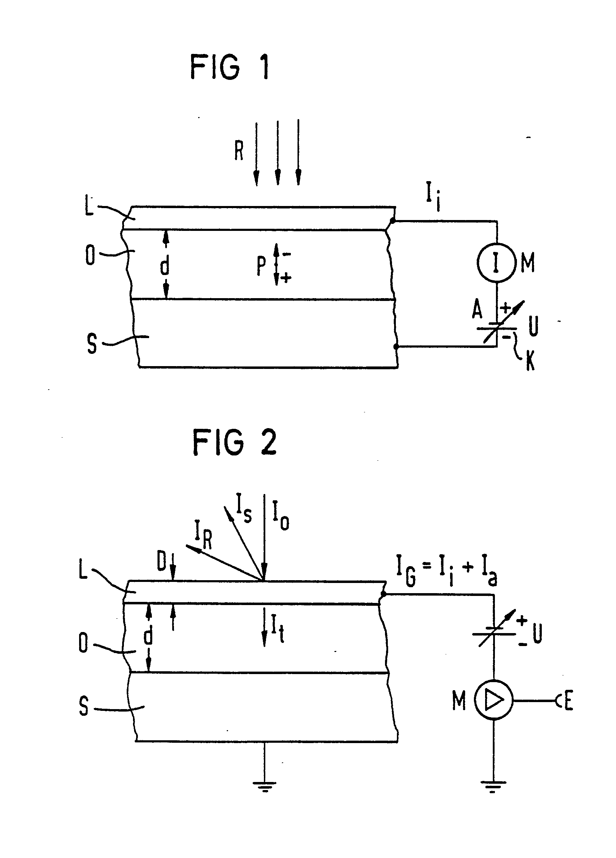

Fig. 1 zeigt eine schematische Darstellung einer Versuchsanordnung für ein erfindungsgemäßes Verfahren. Durch ionisierende Strahlung R, beispielsweise Elektronen-, Röntgenstrahlen, Licht, werden in einem Isolator O Ladungsträgerpaare P erzeugt. Wird an eine Isolatorschicht O der Dicke d ein Feld E = U/d angelegt, so werden die Ladungsträgerpaare P getrennt, die Elektronen wandern zur Anode A und die Löcher wandern zur Kathode K. In Fig. 1 ist das Feld E = U/d beispielsweise zwischen einem Substrat S und einer leitenden Deckschicht L angelegt. Die Strecke 1, welche die Ladungsträger von den Ladungsträgerpaaren P mit der Beweglichkeit $\mu$ während ihrer Lebensdauer $\tau$ zurücklegen, ist von der Feldstärke E abhängig, solange $l < d$ ist:

$$l = \mu \tau E .$$

Im äußeren Stromkreis ergibt sich pro Ladungsträger eines Ladungsträgerpaares P ein Stromimpuls der Dauer $\tau$ und der Höhe $\Delta l$:

$$\Delta l = cv/d = e\mu U/d^2 .$$

Mit e : Elementarladung und v : Driftgeschwindigkeit.

Werden pro Zeiteinheit n Ladungsträger über die Trennung von Ladungsträgerpaaren P erzeugt, so ergibt sich ein gemittelter induzierter Strom:

$$l_i = n\tau \Delta l = ne\mu U/d^2 .$$

Man sieht also, daß der induzierte Strom $l_i$ ein Maß für die zwischen dem Substrat S und der leitenden Deckschicht L angelegte Potentialdifferenz U ist. Der induzierte Strom $l_i$ wird mit dem Meßgerät M gemessen.

Fig. 2 zeigt die Darstellung einer Versuchsanordnung für ein erfindungsgemäßes Verfahren in einem Raster-Elektronenmikroskop. Zur Berechnung eines von einem Elektronenstrahl R induzierten Stromes $l_i$ (EBIC) geht man vereinfachend davon aus, daß der gesamte durch die leitende Deckschicht L transmittierte Primärelektronenstrom

$$l_t = (1 - \varepsilon) l_0$$

(mit $\varepsilon$ : Anteil der in der Deckschicht L absorbierten Elektronen) in der Isolatorschicht absorbiert wird und dort Ladungsträger mit einer über die Dicke d der Isolatorschicht O konstanten Dichte erzeugt. Ist g die Anzahl der pro einfallendes Elektron erzeugten Ladungsträger, so ist

$$n = l_t g/c = g(1 - \varepsilon) l_0/e .$$

Damit ergibt sich daraus ein induzierter Strom $l_i$ von

$$l_i = l_0 g(1 - \varepsilon) \tau\mu U/d^2 .$$

Diesem induzierten Strom $l_i$ überlagert sich im äußeren Stromkreis ein weiterer, von der leitenden Deckschicht L abfließender Strom $l_a$. Dieser abfließende Strom $l_a$ berechnet sich wie folgt: $\varepsilon l_0$ ist derjenige Anteil des Primärelektronenstromes $l_0$, der die leitfähige Deckschicht L nicht passiert. Dieser die leitfähige Deckschicht L nicht passierende Stromanteil setzt sich zusammen aus dem Rückstreuelektronenstrom $l_R = \eta l_0$ (mit $\eta$ Rückstreukoeffizient), dem Sekundärelektronenstrom $l_S = \delta l_0$ (mit $\delta$ : Sekundärelektronenausbeute) und dem über den äußeren Stromkreis abfließenden Strom $l_a$. Somit wird

$$l_a = \varepsilon l_0 - l_R - l_S = (\varepsilon - \sigma) l_0$$

mit $\sigma = \eta + \delta$.

Ist zwischen der leitenden Deckschicht L und dem Substrat S eine Spannung U angelegt, so beträgt somit der in dem Meßgerät M meßbare Gesamtstrom $l_G$:

$$l_G = l_a + l_i$$
$$= (\varepsilon - \sigma) l_0 + (1 - \varepsilon) g\tau\mu l_0 U/d^2 .$$

Dieser meßbare Gesamtstrom $l_G$ enthält einen von der Spannung U unabhängigen Anteil, nämlich den abfließenden Strom $l_a$, und einen linear von der Spannung U abhängigen Anteil, nämlich den induzierten Strom $l_i$. Über den Anschluß E kann das gemessene Signal für den Gesamtstrom $l_g$ auf einem Video-Schirm sichtbar gemacht werden.

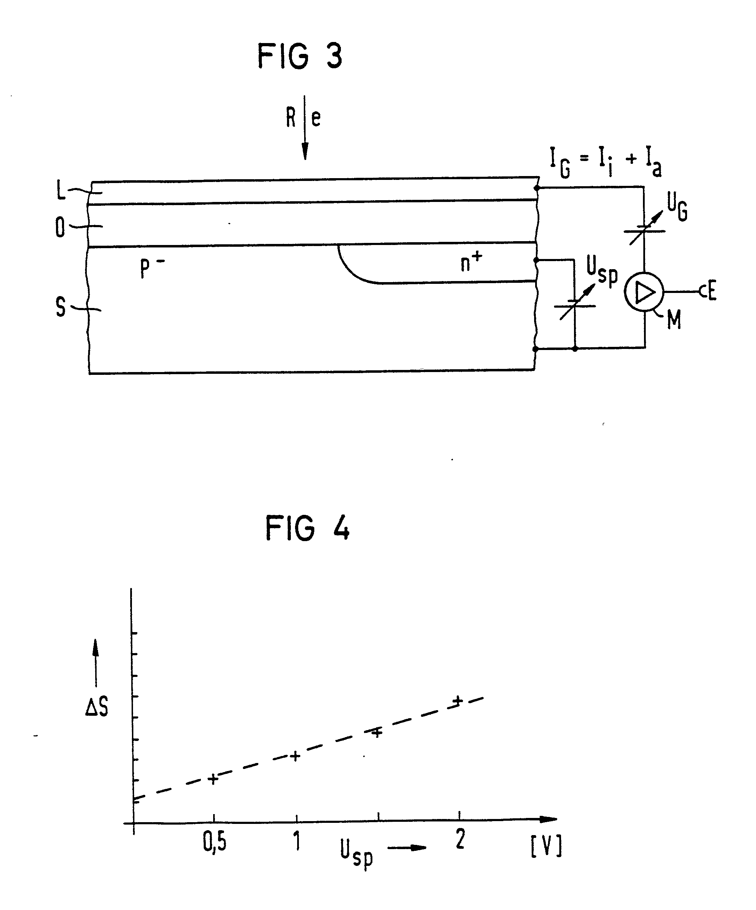

Fig. 3 zeigt die Darstellung einer Versuchsanordnung für ein erfindungsgemäßes Verfahren, mit dem sich ein pn-Übergang in einer MOS-Struktur lokalisieren läßt. Die Ortsauflösung für die Potentialmessung mittels elektronenstrahl-induziertem Strom (EBIC) hängt vom Durchmesser $d_0$ des Primärelektronenstrahls R und von dessen Verbreiterung $\Delta x$ in der leitenden Deckschicht L und in der Isolatorschicht O ab. Bei 2,5 kV Beschleunigungsspannung für den Primärelektronenstrahl R und einem Strahlstrom $l_0$ von $10^{-9}$ A läßt sich mit den üblichen Wolfram-Haarnadelkathoden ein Strahldruchmesser des Primärelektronenstrahls R von $d_0 \approx 0,15$ $\mu$m erreichen.

**0 107 772**

Die Strahlverbreiterung $\Delta x$ entspricht etwa der Eindringtiefe des Primörelektronenstrahls R in einen Festkörper und diese Eindringtiefe beträgt für 2,5 kV-Elektronen sowohl in Aluminium Al, Silizium Si und Siliziumdioxid $SiO_2$ jeweils ca. 0,15 $\mu$m. Bei einer Anordnung nach Fig. 3, bei der die leitende Deckschicht L aus Aluminium Al, die isolierende Schicht O aus Siliziumdioxid $SiO_2$ und das Substrat aus Silizium Si bestehen, kann man also mit einem Auflösungsvermögen von ca. 0,3 $\mu$m rechnen. Einen Einfluß der Ladungsträger-Diffusionslänge 1 (für Elektronen in Siliziumdioxid $SiO_2$ beträgt 1 etwa $10^{-2}$ $\mu$m) kann man demgegenüber vernachlässigen.

Wird eine Festkörperstruktur von der in Fig. 3 gezeigten Art in einem Raster-Elektronenmikroskop abgerastert, so lassen sich aus dem Signalverlauf für den meßbaren Gesamtstrom $I_G$ im Meßgerät M der pn-Übergang im Substrat S lokalisieren und Rückschlüsse auf die an der Oberfläche des Substrats S vorhandenen Potentiale ziehen.

Fig. 4 zeigt das Ergebnis einer solchen Messung. Fig. 4 zeigt den Signalhub $\Delta S$ in Abhängigkeit von der am pn-Übergang im Substrat S angelegten Sperrspannung $U_{sp}$. Im p-Si-Substrat S von Fig. 3, welches einen Widerstand von 10 $\Omega$ cm besitzt, befinden sich $n^+$-implantierte Gebiete mit einer Tiefe von etwa 0,3 $\mu$m. Das Substrat S ist ganzflächig mit 100 nm Hochtemperaturoxid $SiO_2$ und mit 330 Å Aluminium Al beschichtet. Mit dem Primärelektronenstrahl R kann ein und dieselbe Linie über den pn-Übergang hinweg bei verschiedenen Sperrspannungen $U_{sp}$ abgetastet werden. Die zwischen dem Substrat S und der leitenden Deckschicht L angelegte Spannung $U_G$ beträgt dabei beispielsweise $-$ 9 V. Die aus den Linienabtastungen mittels Primärelektronenstrahl-Abrasterung sich ergebenden Kurven liefernden Signalhub $\Delta S$ am pn-Übergang in Abhängigkeit von der an diesem pn-Übergang angelegten Sperrspannung $U_{sp}$. Dieser Signalhub $\Delta S$ ergibt die in Fig. 4 dargestellte erwartete lineare Abhängigkeit von der Sperrspannung $U_{sp}$. Der Signalhub $\Delta S$ bei einer Sperrspannung $U_{sp} = 0$ V wird durch die Diffusionsspannung hervorgerufen.

Eine Meßanordnung nach Fig. 3 kann geeicht werden. Dann ist es mit einem erfindungsgemäßen Verfahren möglich, Potentiale an Festkörpersubstanz, die unter mindestens einer isolierenden Schicht und mindestens einer leitenden Schicht verborgen sind, zu messen. Ein erfindungsgemäßes Verfahren ermöglicht die Messung einer Spannung zwischen einem Meßpunkt, der eine leitende Verbindung zu einem Meßpunkt an der von der Strahlung R induzierten leitfähigen Verbindung (leitfähiger Kanal) aufweist und einem Meßpunkt, dessen Potential eine definierte Relation zum Meßpunkt an der Festkörpersubstanz aufweist.

### Patentansprüche

1. Verfahren zur Messung elektrischer Potentiale an einer Festkörpersubstanz (S), die von einer Oberfläche durch mindestens eine leitende Schicht (L) und mindestens eine isolierende Schicht (O) getrennt ist, bei dem eine ionisierende Strahlung (R) auf mindestens einen Meßpunkt an der Oberfläche gerichtet wird, wodurch eine leitfähige Verbindung zwischen diesem Meßpunkt an der Oberfläche und einem Meßpunkt an der Festkörpersubstanz (S) erzeugt wird, deren elektrisches Potential gemessen werden soll, dadurch gekennzeichnet, daß zwischen der leitenden Schicht (L) und der Festkörpersubstanz (S) eine Potentialdifferenz aufgebaut wird, daß der von einer ionisierenden Strahlung (R) in der isolierenden Schicht (O) induzierte Probenstrom ($I_i$) gemessen wird und daß aus der Messung des von der zwischen der leitenden Schicht (L) und dem Meßpunkt auf der Festkörpersubstanz (S) bestehenden Potentialdifferenz abhängigen induzierten Probenstromes ($I_i$) das elektrische Potential des Meßpunktes auf der Festkörpersubstanz (S) bestimmt wird.

2. Verfahren nach Anspruch 1, dadurch gekennzeichnet, daß elektrische Inhomogenitäten an der Festkörpersubstanz (S) lokalisiert und gemessen werden.

### Claims

1. A method of measuring electric potentials on a solid-state substance (S) separated from a surface by at least one conductive layer (L) and at least one insulating layer (O), wherein an ionising beam (R) is directed towards at least one measurement point on the surface to produce a conductive connection between this measurement point on the surface and a measurement point on the solid-state substance (S) whose electric potential is to be measured, characterised in that a potential difference is formed between the conductive layer (L) and the solid-state substance (S) ; that the sample current ($I_i$) induced by an ionising beam (R) in the insulating layer (O) is measured ; and that the electric potential of the measurement point on the solid-state substance (S) is determined from the measurement of the induced sample current ($I_i$), which is dependent upon the potential difference existing between the conductive layer (L) and the measurement point on the solid-state substance (S).

2. A method as claimed in Claim 1, characterised in that electric inhomogeneities on the solid-state substance (S) are localised and measured.

4

**0 107 772**

### Revendications

1. Procédé pour mesurer des potentiels électriques présents sur une substance à l'état solide (S), qui est séparée d'une surface par au moins une couche conductrice (L) et par au moins une couche isolante (O), et selon lequel on dirige un rayonnement ionisant (R) sur au moins un point de mesure sur la surface, ce qui établit une liaison conductrice entre ce point de mesure situé sur la surface et un point de mesure situé sur la substance à l'état solide (S), dont le potentiel électrique doit être mesuré, caractérisé en ce qu'on établit une différence de potentiel entre la couche conductrice (L) et la substance à l'état solide (S), qu'on mesure le courant d'essai ($I_i$), qui est induit par un rayonnement ionisant (R) dans la couche isolante (O), et qu'on détermine, à partir de la mesure du courant d'essai induit ($I_i$), qui est fonction de la différence de potentiel existant entre la couche conductrice (L) et le point de mesure situé sur la substance à l'état solide (S), le potentiel électrique du point de mesure sur cette dernière.

2. Procédé suivant la revendication 1, caractérisé par le fait qu'on localise et on mesure des hétérogénéités électriques sur la substance à l'état solide (S).

5

# FIG 1

# FIG 2

$$I_G = I_i + I_a$$

## FIG 3

$R \mid e$

$I_G = I_i + I_a$

L

O

P⁻            n⁺            $U_{sp}$    $U_G$

S                                        M    C E

## FIG 4

ΔS

0,5        1        $U_{sp} \longrightarrow$        2        [V]

2